# EUROPEAN PATENT SPECIFICATION

(11) **EP 0 616 257 B1**
(45) Date of publication and mention of the grant of the patent: **29.07.1998**
(21) Application number: 93309513.5
(22) Date of filing: 29.11.1993
(51) Int. Cl.: G03F 3/10, B41F 27/12, B41F 30/00

(54) **Image transfer method and material**
Verfahren und Material zur Bild-Übertragung
Procédé et méthode pour le transfert de l'image

(30) Priority: 18.03.1993 JP 58833/93
(43) Date of publication of application: 21.09.1994
(73) Proprietor: TOYO INK MANUFACTURING CO., LTD., Tokyo (JP)
(72) Inventor: Imabayashi, Arata, c/o Toyo Ink Manuf.Co.,Ltd., Chuo-ku, Tokyo (US); Tanaka, Yasuhiro, c/o Toyo Ink Manuf.Co.,Ltd., Chuo-ku, Tokyo (US)
(74) Representative: Price, Nigel John King

(56) References cited:
- EP-A- 0 350 195
- EP-A- 0 455 068
- PATENT ABSTRACTS OF JAPAN vol. 12, no. 413 (P-780) 2 November 1988 & JP-A-63 149 651 (KONICA CORP) 22 June 1988

## Description

The present invention relates to an image transfer method. More specifically, it relates to an image transfer method using an image-forming material consisting essentially of a substrate, a colouring photosensitive layer and a protection film, which permits excellent registration and therefore gives an aesthetically fine multi-colour prepress proof or print.

Single-colour and multi-colour prepress proof sheets suitable for proof printing have been recently increasingly produced by imagewise exposing photosensitive layer(s) of image-forming material(s) to form image(s) and transferring the image(s) to an image receptor under heat, generally around 100°C. The image-forming material is generally formed of a substrate, a photosensitive layer (formed on one surface of the substrate) and a protection film, for instance as disclosed in document EP-A-0,350,195. The substrate and the protection film is selected from thin films or sheets formed from a material such as cellulose acetate, polystyrene, polyvinyl chloride or polyethylene terephthalate. The image receptor is selected from paper and a film. The photosensitive layer contains a dye and/or a pigment and a photopolymerizable compound.

For producing the above prepress proof sheet, there has been proposed an image transfer method in which a platen, to which an image-forming material is attached, and a transfer cylinder, to which an image receptor is attached, are rotated so that a photosensitive layer of the image-forming material and an image receptor are brought into contact with each other under pressure, whereby an image formed in the photosensitive layer by imagewise exposing is transferred to the image receptor in a nip portion formed by the platen and the transfer cylinder. A multi-colour print or prepress proof sheet is produced by colour-scanning an original of a multi-colour image, imagewise exposing image-forming materials corresponding to separated colours, e.g., yellow, magenta, cyan and black to form images of these colours in the image forming materials (one image of one colour in one image-forming material), and consecutively transferring these formed images to one image receptor.

For attaching the image-forming material to the platen, a pin bar is generally used to facilitate the registering of each colour. The pin bar has a structure in which a plurality of pins are provided on a plate extending in the axial direction of the platen. However, the registering accuracy with the pin bar has not yet been fully satisfactory.

It is an aim of the Applicant to provide an image transfer sheet and method which can give a multi-colour prepress proof and a multi-colour print with excellent registration.

It is another aim of the Applicant to provide an image transfer method using an image-forming material which can give a multi-colour prepress proof and a multi-colour print with excellent registration.

According to one aspect of the present invention, there is provided a sheet of image-forming material for use in an image transfer method in which the sheet is mounted on a roller and a nip is formed between the roller and another surface, the sheet comprising a photosensitive layer, a protective film exfoliatively attached to the photosensitive layer and a substrate positioned on the other side of the photosensitive layer to the protective film; characterised in that
the substrate is held in tension by the protective film in a direction that will correspond to the direction of rotation of the roller, in use.

The present invention also contemplates a method of using such a sheet in an image transfer method, the method comprising the use of a sheet as defined above in an image transfer method, the method comprising mounting the sheet on a roller, with the tension in the substrate substantially at right angles to a line parallel to the axis of the roller, and then peeling off the protective film whereby the substrate shrinks to attach more tightly to the roller.

The invention will be further described, by way of non-limitative example, with reference to the drawings, in which:-

Fig. 1 is a schematic view of an image transfer apparatus suitable for the image transfer method of the present invention.

Fig. 2 is a schematic view of the interior of an image-forming material showing the state of internal stress when the elastic strain percentage of the substrate is greater than the elastic strain percentage of the protective film.

Fig. 3 is a schematic view of the interior of an image-forming material showing the state of internal stress when the elastic strain percentage of the substrate is smaller than the elastic strain percentage of the protective film.

The present invention will be detailed hereinafter with reference to drawings.

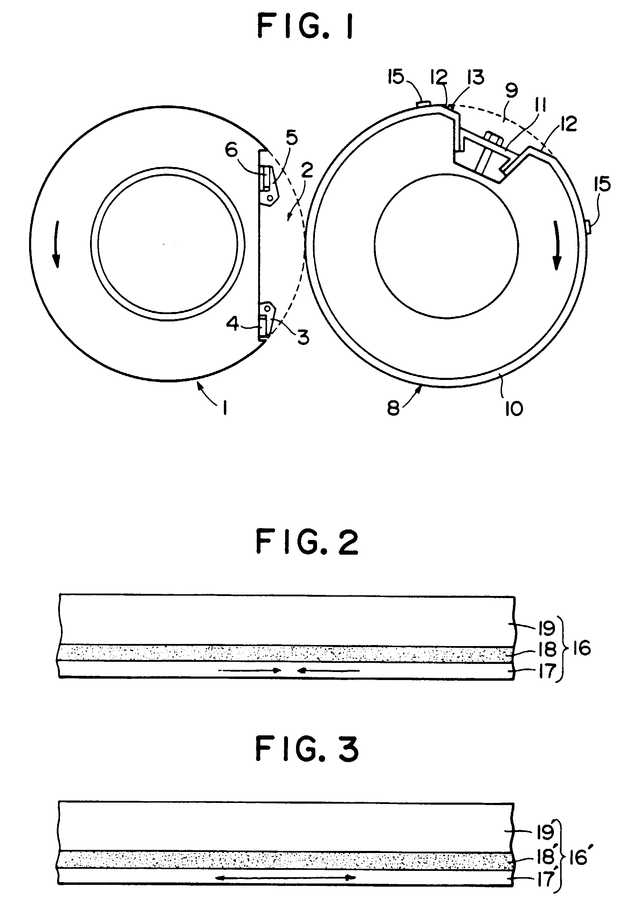

Fig. 1 is a schematic view of an image transfer apparatus suitable for the image transfer method of the present invention.

The constitution of a transfer cylinder 1 will be explained below with reference to Fig. 1. The transfer cylinder 1 has a partial cut-off portion 2 formed on part of its surface. The partial cut-off portion has a clamp (top end clamp) consisting of a holder 3 for holding the top end side of an image receptor (not shown) such as paper and a holder seat 4 and a clamp (bottom end clamp) consisting of a holder 5 for holding the bottom end of the image receptor and a holder seat 6. The image receptor is attached to the transfer cylinder by allowing the top end clamp to hold the top end side of the image receptor, turning the transfer cylinder in the direction of an arrow while the image receptor is tensioned, and allowing the bottom end clamp to hold the bottom end side of the image receptor.

The constitution of a platen 8 will be explained below with reference to Fig. 1. The platen 8 has a partial cut-out portion 9. The surface of the platen 8 is wrapped with a blanket 10, and the top and bottom end sides of the blanket 10 are fixed within the partial cut-out portion with a blanket fixing means 11. The partial cut-out portion 9 has two slope portions 12 extending to a platen surface (circumferential surface), and one slope portion is provided with a pin bar 13. The pin bar 13 is pressed on a platen surface with the blanket 10 which has holes in places corresponding to pin positions of the pin bar 13. The pin bar 13 has so small a height that its top does not protrude over the circumferential surface of the platen 8. That is so that the pin bar 13 and the surface of the transfer cylinder 1 are not damaged in the rotation of the platen 8 and the transfer cylinder 1. An adhesive tape 15 is provided on a platen surface near the slope portion where the pin bar 13 is located, and another adhesive tape 15 is also provided on a platen surface near the other slope portion. An image-forming material (not shown) formed of a substrate, a photosensitive layer containing a dye and/or a pigment and a photopolymerizable compound and a protective film has holes corresponding to pins of the pin bar 13, and the holes are located in the top end side of the image-forming material. The image-forming material is attached as follows. The holes of the image-forming material are fit to the pins of the pin bar 13. Then, the platen 8 is turned in the direction of an arrow, and the top side of the image-forming material is fixed with the adhesive tape 15, followed by fixing the bottom side of the image-forming material with the other adhesive tape 15.

After the image-forming material is attached to the platen, the protective film is peeled off. Then, the transfer cylinder 1 and the platen 8 are rotated synchronously to introduce the image-forming material and the image receptor into a nip formed by the transfer cylinder and the platen so that the photosensitive layer and the image receptor come into contact with each other, whereby part of the photosensitive layer is selectively transferred to the image receptor to form a transfer image.

The image-forming material used in the image transfer method of the present invention has characteristic features in that the tension applied to the photosensitive layer and the tension applied to the protective film are well-balanced when the protective film is attached to the photosensitive layer in a step of preparing the image-forming material, so that the image-forming material can be attached onto the platen in a state in which the substrate is free of a crinkle and a slacking thereby to obtain excellent registration accuracy.

In the present invention, the elastic strain percentage refers to a ratio of the extension of the elongated protective layer or substrate to its original length.

Fig. 2 schematically shows the function of the image-forming material used in the present invention in which numeral 16 indicates an image-forming material. The image-forming material 16 consists essentially of a substrate 17, a photosensitive layer 18 formed on the substrate 17 and a protective film 19 attached to the photosensitive layer 18. The protective film generally has a thickness of 40 to 200 µm. The substrate generally has a thickness of 5 to 30 µm. The thickness of the protective film is generally 5 to 25 times as large as the thickness of the substrate. In Fig. 2, arrows show states of internal stresses when the protective film is attached to the photosensitive layer in a state in which the elastic strain percentage of the substrate under tension is greater than the elastic strain percentage of the protective film under tension.

The ratio of the elastic strain percentage (B) of the substrate to the elastic strain percentage (A) of the protective film (B/A) is generally 2 to 20, preferably 5 to 18, more preferably 7 to 15. In the image-forming material 16, the protective film 19 has a larger thickness than the substrate 17, and after attached to the photosensitive layer 18, the protective film 19 nearly restores its original length. On the other hand, the substrate 17 adheres to the protective film 19 with the photosensitive layer between them in a state in which the substrate 17 has a greater elastic strain percentage than the protective film 19. After the protective film nearly restores its original length, the substrate 17 is in a state in which its shrinkage is prevented by the protective film 19 and is under tension. This state is indicated by arrows in Fig. 2.

The image-forming material in the above state is attached to the platen, and then the protective film is peeled off from the image-forming material, whereby the substrate which has been released from the constraint by the protective film shrinks by a restoring force to be tightly attached to the platen surface. When the direction in which the tension is applied to the image-forming material is at right angles with the axial direction of rolls (transfer cylinder and platen), the attaching property of the image-forming material improves. When the above direction is parallel with the axial direction of the rolls, the attaching property does not improve.

When the ratio of the elastic strain percentage (B) of the substrate to the elastic strain percentage (A) of the protective film (B/A) exceeds 20, the image-forming material is liable to curl due to a residual stress difference between the front and reverse surfaces thereof, and the workability with the image-forming material decreases. Further, the image-forming material is in a state in which a shearing force is on the photosensitive layer, and the photosensitive layer therefore degrades while the image-forming material is stored.

The ratio of the elastic strain percentage (B) of the substrate to the elastic strain percentage (A) of the protective film (B/A) varies across the image-forming material (in the width direction), and the variation of the above ratio (B/A) is preferably ±20 % of an average strain percentage of the entire image-forming material. When the variation of the above ratio (B/A) exceeds ±20 %, the restoring force greatly varies across the image-forming material, which variation causes a decrease in the attaching property of the substrate to the platen surface.

When the ratio of the elastic strain percentage (B) of the substrate to the elastic strain percentage (A) of the protective film (B/A) is less than 2, the constraining force of the protective film does not sufficiently work on the substrate. As a result, when the protective film is peeled off after the image-forming material is attached to the platen, the substrate is liable to slack on the platen surface. The slacking of the substrate naturally causes poor registration.

Fig. 3 is a schematic view of an interior of an image-forming material showing a state of an internal stress when the elastic strain percentage of the substrate is smaller than the elastic strain percentage of the protective film. Arrows in Fig. 3 indicate the directions of actions of stresses within the image-forming material, in which a compression stress is exerted on the substrate. When the image-forming material shown in Fig. 3 is attached to the platen and then the protective film is peeled, the restoring force of the substrate which has been released from the constraining force of the protective film works in the direction in which the substrate is elongated. As a result, the attaching property of the substrate to the platen surface deteriorates, which causes a crinkle and slacking of the image-forming material and finally causes poor registration.

According to the present invention, there is provided an image transfer method which can prevent poor registration and gives an esthetically fine multi-colour prepress proof and a multi-colour print with excellent registration.

## Claims

1. A sheet of image-forming material (16) for use in an image transfer method in which the sheet (16) is mounted on a roller (8) and a nip is formed between the roller (8) and another surface (1), the sheet comprising a photosensitive layer (18), a protective film (19) exfoliatively attached to the photosensitive layer (18) and a substrate (17) positioned on the other side of the photosensitive layer (18) to the protective film (19);
characterised in that
the substrate (17) is held in tension by the protective film (19) in a direction that will correspond to the direction of rotation of the roller (8), in use.

2. A sheet as claimed in claim 1, wherein the elastic strain percentage (B) of the substrate (17) is greater than the elastic strain percentage (A) of the protective film (19).

3. A sheet as claimed in claim 2, wherein, prior to the photosensitive layer (18), the protective film (19) and the substrate (17) being layered together, the ratio (B/A) of the elastic strain percentage of the substrate (17) to the elastic strain percentage of the protective film (19) is between 2 and 20.

4. A sheet as claimed in claim 3, wherein the said ratio (B/A) is between 5 and 18.

5. A sheet as claimed in any of claims 2 to 4, wherein prior to the photosensitive layer (18), the protective film (19) and the substrate (17) being layered together, the ratio (B/A) of the elastic strain percentage of the substrate (17) to the elastic strain percentage of the protective film (19) varies by up to ± 20% across the width of the image-forming material (16) in a direction perpendicular to the direction of rotation of the roller (8), in use.

6. A sheet as claimed in any of the preceding claims, wherein the sheet (16) is provided at one edge thereof with holes for engagement with a pin bar (13) of the roller (8), said edge constituting the leading edge of the sheet (16) in the direction of rotation of the roller (8) when the sheet is mounted on the roller, and being positioned substantially parallel to the axis of the roller (8).

7. In combination, a sheet (16) according to any one of the preceding claims, with image-forming apparatus comprising a roller (8) and another surface (1), wherein the sheet (16) of image-forming material is mounted on the roller (8) with said tension in said substrate being in a direction substantially at right angles to a line parallel to the axis of the roller (8).

8. The combination as claimed in claim 7, wherein the sheet is mounted on the roller (8) by being stuck to the roller in the region of the leading and trailing ends of the sheet in the direction of rotation of the roller.

9. The combination as claimed in claim 7 or 8, wherein the roller (8) is provided with strips of adhesive tape (15) corresponding to the positions of the leading and trailing ends of the sheet when mounted on the roller.

10. The use of a sheet as defined in any one of claims 1 to 6 in an image transfer method, the method comprising mounting the sheet (16) on a roller (8), with the tension in the substrate (17) substantially at right angles to a line parallel to the axis of the roller (8), and then peeling off the protective film (19) whereby the substrate (17) shrinks to attach more tightly to the roller (8).

11. The use claimed in claim 10, the method further comprising the subsequent step of introducing the image-forming material into a nip formed between the roller (8) and another surface (1) so that the photosensitive layer (18) of the image-forming material (16) and an image receptor come into contact with each other selectively to transfer part of the photosensitive layer (18) to the image receptor to produce an image thereon.

## Patentansprüche

1. Folie aus bilderzeugendem Material (16) zur Verwendung bei einem Bildübertragungsverfahren, bei dem die Folie (16) an einer Walze (8) befestigt ist, und zwischen der Walze (8) und einer weiteren Oberfläche (1) ein Spalt vorhanden ist, wobei die Folie folgendes umfaßt: eine lichtempfindliche Schicht (18), eine Schutzfolie (19), die ablösbar an der lichtempfindlichen Schicht (18) befestigt ist, und ein Substrat (17), das auf der der Schutzfolie (19) entgegengesetzten Seite der lichtempfindlichen Schicht (18) angeordnet ist;
dadurch gekennzeichnet, daß
das Substrat (17) durch die Schutzfolie (19) in einer Richtung in Spannung gehalten wird, die im Gebrauch der Drehrichtung der Walze (8) entsprechen wird.

2. Folie nach Anspruch 1, bei der der Prozentsatz (B) der elastischen Dehnung des Substrats (17) größer ist als der Prozentsatz (A) der elastischen Dehnung der Schutzfolie (19).

3. Folie nach Anspruch 2, bei der vor dem Aufeinanderschichten der lichtempfindlichen Schicht (18), der Schutzfolie (19) und des Substrats (17) das Verhältnis (B/A) des Prozentsatzes der elastischen Dehnung des Substrats (17) zum Prozentsatz der elastischen Dehnung der Schutzfolie (19) zwischen 2 und 20 liegt.

4. Folie nach Anspruch 3, bei der das Verhältnis (B/A) zwischen 5 und 18 liegt.

5. Folie nach einem der Ansprüche 2 bis 4, bei der vor dem Aufeinanderschichten der lichtempfindlichen Schicht (18), der Schutzfolie (19) und des Substrats (17) das Verhältnis (B/A) des Prozentsatzes der elastischen Dehnung des Substrats (17) zum Prozentsatz der elastischen Dehnung der Schutzfolie (19) über die Breite des bilderzeugenden Materials (16) in einer Richtung senkrecht zur Drehrichtung der Walze (8) im Gebrauch um bis zu ± 20% schwankt.

6. Folie nach einem der vorhergehenden Ansprüche, bei der die Folie (16) an einer Kante mit Löchern versehen ist, in die eine Nadelleiste (13) der Walze (8) eingreifen kann, wobei die Kante die Vorderkante der Folie (16) in Drehrichtung der Walze (8) darstellt, wenn die Folie an der Walze befestigt ist, und im wesentlichen parallel zur Achse der Walze (8) verläuft.

7. Folie (16) nach einem der vorhergehenden Ansprüche in Kombination mit einer bilderzeugenden Vorrichtung, welche eine Walze (8) und eine weitere Oberfläche (1) umfaßt, wobei die Folie (16) aus bilderzeugendem Material an der Walze (8) befestigt ist und die Spannung in dem Substrat im wesentlichen rechtwinklig zu einer Linie verläuft, die parallel ist zu der Achse der Walze (8).

8. Kombination nach Anspruch 7, bei der die Folie an der Walze (8) befestigt ist, indem sie im Bereich des vorderen und hinteren Endes der Folie in Drehrichtung der Walze an der Walze klebt.

9. Kombination nach Anspruch 7 oder 8, bei der die Walze (8) mit Klebestreifen (15) versehen ist, die den Positionen des vorderen und hinteren Endes der Folie entsprechen, wenn diese an der Walze befestigt ist.

10. Verwendung einer Folie nach einem der Ansprüche 1 bis 6 bei einem Bildübertragungsverfahren, wobei das Verfahren die folgenden Schritte umfaßt: Befestigen der Folie (16) an einer Walze (8), wobei die Spannung in dem Substrat (17) im wesentlichen rechtwinklig zu einer Linie verläuft, die parallel ist zu der Achse der Walze (8), und dann Ablösen der Schutzfolie (19), so daß das Substrat (17) zusammenschrumpft und damit fester an der Walze (8) haftet.

11. Verwendung nach Anspruch 10, wobei das Verfahren des weiteren anschließend den Schritt des Einführens des bilderzeugenden Materials in einen Spalt zwischen der Walze (8) und einer weiteren Oberfläche (1) umfaßt, so daß die lichtempfindliche Schicht (18) des bilderzeugenden Materials (16) und eine Bildempfangsschicht wahlweise miteinander in Kontakt kommen, um einen Teil der lichtempfindlichen Schicht (18) auf die Bildempfangsschicht zu übertragen, um ein Bild darauf zu erzeugen.

## Revendications

1. Feuille d'un matériau de formation d'images (16) destinée à être utilisée dans un procédé de transfert d'images dans lequel la feuille (16) est montée sur un cylindre (8) et un intervalle est formé entre le cylindre (8) et une autre surface (1), la feuille comprenant une couche photosensible (18), un film protecteur (19) attaché de manière à pouvoir être arraché sur la couche photosensible (18) et un substrat (17) positionné sur l'autre côté de la couche photosensible (18) par rapport au film protecteur (19), caractérisée en ce que :
le substrat (17) est tenu en tension par le film protecteur (19) dans une direction qui correspondra au sens de rotation du cylindre (8) en utilisation.

2. Feuille selon la revendication 1, dans laquelle le pourcentage de déformation élastique (B) du substrat (17) est supérieur au pourcentage de déformation élastique (A) du film protecteur (19).

3. Feuille selon la revendication 2, dans laquelle, avant que la couche photosensible (18), le film protecteur (19) et le substrat (17) aient été stratifiés ensemble, le rapport (B/A) du pourcentage de déformation élastique du substrat (17) au pourcentage de déformation élastique du film protecteur (19) est compris entre 2 et 20.

4. Feuille selon la revendication 3, dans laquelle ledit rapport (B/A) est compris entre 5 et 18.

5. Feuille selon l'une des revendications 2 à 4, dans laquelle, avant que la couche photosensible (18), le film protecteur (19) et le substrat (17) aient été stratifiés ensemble, le rapport (B/A) du pourcentage de déformation élastique du substrat (17) au pourcentage de déformation élastique du film protecteur (19) varie jusqu'à ± 20 % en travers de la largeur du matériau de formation d'images (16) dans une direction perpendiculaire au sens de rotation du cylindre (8) en utilisation.

6. Feuille selon l'une des revendications précédentes, dans laquelle la feuille (16) présente, au niveau d'un de ses bords, des trous pour coopérer avec une barre à picots (13) du cylindre (8), ledit bord constituant le bord avant de la feuille (16) dans le sens de rotation du cylindre (8) lorsque la feuille est montée sur le cylindre, et étant positionné pratiquement parallèle à l'axe du cylindre (8).

7. En combinaison, une feuille (16) selon l'une quelconque des revendications précédentes avec un appareil de formation d'images comprenant un cylindre (8) et une autre surface (1), dans laquelle la feuille (16) du matériau de formation d'images est montée sur le cylindre (8) avec ladite tension dans ledit substrat s'exerçant dans une direction pratiquement perpendiculaire à une ligne parallèle à l'axe du cylindre (8).

8. Combinaison selon la revendication 7, dans laquelle la feuille est montée sur le cylindre (8) en étant fixée sur le cylindre dans la région de l'extrémité avant et de l'extrémité arrière de la feuille dans le sens de rotation du cylindre.

9. Combinaison selon la revendication 7 ou la revendication 8, dans laquelle le cylindre (8) est équipé de bandes de ruban adhésif (15) correspondant aux positions des extrémités avant et arrière de la feuille lorsqu'elle est montée sur le cylindre.

10. Utilisation d'une feuille telle que définie dans l'une quelconque des revendications 1 à 6 dans un procédé de transfert d'images, le procédé comprenant le montage de la feuille (16) sur un cylindre (8), avec la tension dans le substrat (17) s'exerçant pratiquement perpendiculairement à une ligne parallèle à l'axe du cylindre (8), et l'arrachage ultérieur du film protecteur (19), d'où il résulte que le substrat (17) se rétrécit pour se fixer plus étroitement sur le cylindre (8).

11. Utilisation selon la revendication 10, le procédé comprenant en outre l'étape ultérieure dans laquelle on introduit le matériau de formation d'images dans un intervalle formé entre le cylindre (8) et une autre surface (1) de façon à amener en contact l'un avec l'autre la couche photosensible (18) du matériau de formation d'images (16) et un récepteur d'images, pour transférer sélectivement une partie de la couche photosensible (18) sur le récepteur d'images pour produire une image sur celui-ci.
